(19) Europäisches Patentamt / European Patent Office / Office européen des brevets

(11) **EP 2 834 656 B1**

(12) **EUROPÄISCHE PATENTSCHRIFT**

(45) Veröffentlichungstag und Bekanntmachung des Hinweises auf die Patenterteilung:
**31.07.2019 Patentblatt 2019/31**

(21) Anmeldenummer: **13723729.3**

(22) Anmeldetag: **08.05.2013**

(51) Int Cl.:
***G01R 31/36*** *(2019.01)*

(86) Internationale Anmeldenummer:
**PCT/EP2013/059628**

(87) Internationale Veröffentlichungsnummer:
**WO 2013/167678 (14.11.2013 Gazette 2013/46)**

(54) **VERFAHREN ZUR BESTIMMUNG EINES GESAMTKAPAZITÄTSVERLUSTS EINER SEKUNDÄRZELLE**

METHOD FOR DETERMINING AN OVERALL LOSS OF CAPACITY OF A SECONDARY CELL

PROCÉDÉ DE DÉTERMINATION D'UNE PERTE DE CAPACITÉ TOTALE D'UN ÉLÉMENT SECONDAIRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **11.05.2012 DE 102012207860**

(43) Veröffentlichungstag der Anmeldung:
**11.02.2015 Patentblatt 2015/07**

(73) Patentinhaber: **Siemens Aktiengesellschaft 80333 München (DE)**

(72) Erfinder:
• **MOST, Dieter 91052 Erlangen (DE)**
• **WEYDANZ, Wolfgang 91054 Buckenhof (DE)**
• **WOLFSCHMIDT, Holger 91056 Erlangen (DE)**

(56) Entgegenhaltungen:
EP-A2- 1 387 177     EP-A2- 1 450 173
DE-A1- 19 540 827

EP 2 834 656 B1

**EP 2 834 656 B1**

**Beschreibung**

Die Erfindung betrifft ein Verfahren zur Bestimmung eines Gesamtkapazitätsverlusts einer Sekundärzelle welches Alterungsprozesse der Sekundärzelle abbildet.

Durch den zunehmenden Anteil an erneuerbaren Energien in der Stromerzeugungsinfrastruktur kommt es zu Fluktuationen in der Menge des erzeugten Stromes im Stromnetz. Diese Fluktuationen während der Stromerzeugung müssen ausgeglichen werden, um die Systemstabilität im Stromnetz zu gewährleisten.

Die Fluktuationen des Stromes im Stromnetz sind nicht planbar und teilweise sehr stark. Deshalb sind Energiespeicher nötig, welche dem Stromnetz Überschussstrom abnehmen können oder bei Stromknappheit Strom in das Stromnetz einspeisen.

Eine bekannte Möglichkeit Strom zu speichern und abzugeben stellen Sekundärzellen, insbesondere wiederaufladbare Batterien oder Akkumulatoren, dar. Sie bieten die Möglichkeit, elektrische Energie als chemische Energie zu speichern und sie bei Bedarf wieder abzugeben. Sekundärzellen bieten weiterhin den Vorteil, dass die Kapazität durch den Einsatz sogenannter Pakete nach Bedarf anpassbar ist. Ein Paket stellt dabei einen Verbund von mindestens zwei Sekundärzellen dar.

Sekundärzellen unterliegen aber Alterungsprozessen, welche zu einem Kapazitätsverlust führen. Diese Alterungsprozesse betreffen das Laden und das Entladen der Sekundärzelle. Der Kapazitätsverlust ist abhängig von insbesondere der Temperatur, der Zeit, der Strombelastung, der Entladetiefe und dem Ladezustand bei dem eine Sekundärzelle betrieben oder gelagert wird. Die Bestimmung des Kapazitätsverlustes erfolgt entweder direkt durch Messung - was im Betrieb meist nicht möglich ist - oder durch Simulation anhand mathematischer Modelle. In diesen Modellen wird ein einfacher Zusammenhang von Ladungsdurchsatz und Kapazitätsverlust hergestellt. Dieser Zusammenhang lässt sich mit Formel 1 beschreiben.

$$Q_{loss} = B \cdot \exp\left(\frac{-E_a}{RT}\right) \cdot (I * t)^z$$

Formel 1

In Formel 1, welche aus "Cycle-life model for graphite-LiFePO$_4$ cells" (John Wang et al., Journal of Power Sources 196 (2011) 3942-3948), Seite 3945 bekannt ist, beschreibt R die universelle Gaskonstante, T die Temperatur, I den Strom und t die Zeit. Diese Parameter sind fest. B stellt einen Vorfaktor dar, $E_a$ die Aktivierungsenergie und z einen Exponenten. Diese Parameter sind anpassbar. Sie müssen an Randbedingungen jeder speziellen Sekundärzelle angepasst werden, indem Abhängigkeiten von z. B. der Temperatur, der Zeit, der Strombelastung, der Entladetiefe oder dem aktuellen Ladezustand ermittelt werden.

Ändern sich die Randbedingungen während des Betriebs der Sekundärzelle, werden Teil-Kapazitätsverluste bestimmt. Die Teil-Kapazitätsverluste werden dann addiert, um den Gesamtkapazitätsverlust zu bestimmen. Der Zusammenhang der Teil-Kapazitätsverluste wird in der Weise hergestellt, dass der Ladungsdurchsatz zum Ende eines Teil-Kapazitätsverlusts dem Ladungsdurchsatz zu Beginn des nächsten Teil-Kapazitätsverlusts entspricht.

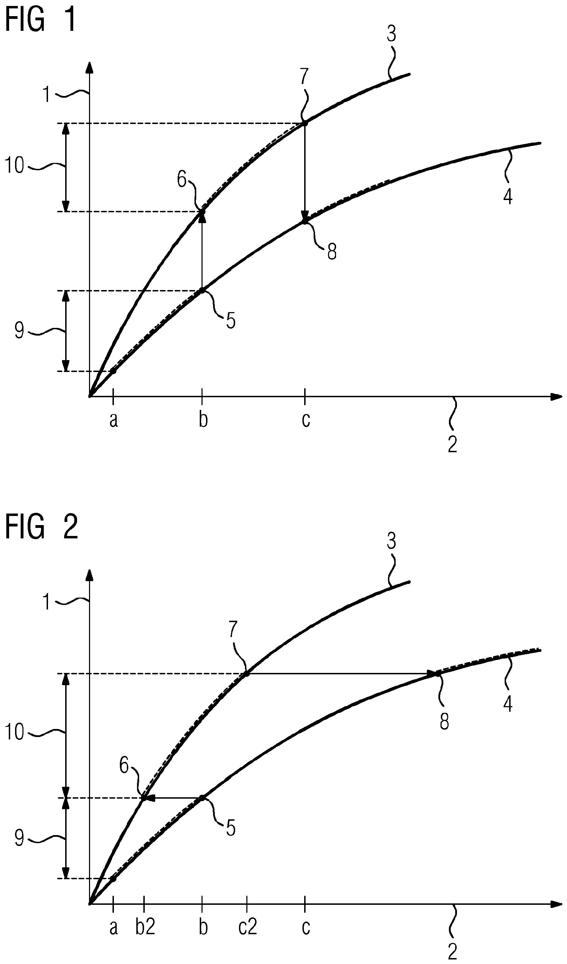

Dieses Vorgehen verdeutlicht Figur 1. Dort ist der Kapazitätsverlust gegen den Ladungsdurchsatz aufgetragen. Zu sehen sind weiterhin zwei Funktionen, die zwei unterschiedliche Randbedingungen A und B beschreiben. Für beide Randbedingungen steigt der Kapazitätsverlust mit zunehmendem Durchsatz. Ändern sich die Randbedingungen wird der Wechsel von der ersten Funktion zu der zweiten Funktion folgendermaßen durchgeführt.

In einem ersten Schritt wird die Sekundärzelle von einem ersten Ladungsdurchsatz a bis zu einem zweiten Ladungsdurchsatz b unter Randbedingung A geschädigt. An einem ersten Endwert 5 ändern sich die Randbedingungen von A nach B. Dabei wird für den Weiterbetrieb unter Randbedingung B für denselben Ladungsdurchsatz der Schnittpunkt mit der Funktion für Randbedingung B bestimmt. Dieser dient nun als zweiter Anfangswert 6 für den Betrieb der Sekundärzelle unter Randbedingung B.

Nach einem Betrieb vom zweiten Ladungsdurchsatz b bis zum dritten Ladungsdurchsatz c bis zum zweiten Endwert 7 ändern sich die Randbedingungen von B nach A. Die Bestimmung des dritten Anfangswerts 8 erfolgt analog bei konstantem Ladungsdurchsatz. Ein erster Teil-Kapazitätsverlust 9 und ein zweiter Teil-Kapazitätsverlust 10 für die Ladungsdurchsatzbereiche a bis b und b bis c werden an der y-Achse abgelesen und addiert.

Nachteilig bei dieser Methode ist, dass die Alterungsprozesse und der sich daraus ergebende Gesamtkapazitätsverlust bestimmt werden, ohne eine Vorschädigung der Sekundärzelle ausreichend mit einzubeziehen. Weiterhin werden Schädigungen insbesondere durch Ereignisse wie große Änderungen eines Ladezustands nicht berücksichtigt. Dadurch ergibt sich ein zu geringer Gesamtkapazitätsverlust, der die Realität unzureichend wiedergibt.

Aus der EP 1 450 173 A2 und der DE 195 40 827 A1 sind Verfahren zur Ermittlung der Alterung beziehungsweise des Alterungszustandes einer Batterie bekannt. Die EP 1 387 177 A2 zeigt ein Verfahren zur Ermittlung des Verschleißes eines elektrochemischen Energiespeichers.

Aufgabe der vorliegenden Erfindung ist es daher, ein Verfahren zur Bestimmung eines Gesamtkapazitätsverlusts einer Sekundärzelle anzugeben, welches die Vorschädigung bei wechselnden Randbedingungen während des Betriebs realitätsnäher wiedergibt.

Die Aufgabe wird durch ein Verfahren mit den Merkmalen von Anspruch 1 gelöst. Die abhängigen Ansprüche betreffen vorteilhafte Weiterbildungen der Erfindung.

Bei dem erfindungsgemäßen Verfahren wird ein Gesamtkapazitätsverlust einer Sekundärzelle bei Durchlaufen eines ersten Intervalls von einem ersten Anfangswert bis zu einem ersten Endwert für den Ladungsdurchsatz und eines sich an das erste Intervall anschließenden zweiten Intervalls von einem zweiten Anfangswert bis zu einem zweiten Endwert für den Ladungsdurchsatz bestimmt, wobei der Gesamtkapazitätsverlust und der Ladungsdurchsatz (2) über den Zusammenhang $Q_{loss} = B \cdot \exp\left(\dfrac{-E_a}{RT}\right) \cdot (I * t)^z$ beschrieben werden. Der Gesamtkapazitätsverlust setzt sich aus Teil-Kapazitätsverlusten zusammen, welche den Gesamtkapazitätsverlust additiv bilden. Dabei wird ein erster Teil-Kapazitätsverlust mittels einer ersten Funktion, welche den Zusammenhang zwischen Ladungsdurchsatz und Kapazitätsverlust mit einer ersten Randbedingung beschreibt, für das erste Intervall bestimmt. Ein zweiter Teil-Kapazitätsverlust wird mittels einer zweiten Funktion, welche den Zusammenhang zwischen Ladungsdurchsatz und Kapazitätsverlust mit einer zweiten Randbedingung beschreibt, für das zweite Intervall bestimmt. Dabei wird das zweite Intervall für die Verwendung in der zweiten Funktion derart verschoben, dass ein Ergebniswert der zweiten Funktion für den zweiten Anfangswert einem Ergebniswert der ersten Funktion für den ersten Endwert entspricht.

Damit wird vorteilhaft erreicht, dass die Vorschädigung der Sekundärzelle besser in die Bestimmung des Gesamtkapazitätsverlustes mit einbezogen wird. Bei einer weiteren Verschiebung des Intervalls erfolgt das Vorgehen analog, wobei das zweite Intervall dann als erstes Intervall und ein drittes Intervall als zweites Intervall bezeichnet wird. Der Gesamtkapazitätsverlust wird dann bereits bei niedrigen Ladungsdurchsätzen realitätsnah, d.h. ausreichend hoch beschrieben. Weiterhin kann der Gesamtkapazitätsverlust an der y-Achse abgelesen werden, da die Teil-Kapazitätsverluste sich direkt aneinander anschließen.

In einer vorteilhaften Ausgestaltung und Weiterbildung der Erfindung wird der Gesamtkapazitätsverlust der Sekundärzelle auf den Gesamtkapazitätsverlust eines Pakets, welches wenigstens aus zwei Sekundärzellen besteht, erweitert. Damit kann der Gesamtkapazitätsverlust eines Pakets von Sekundärzellen ermittelt werden. Die Auswertung dieses Gesamtkapazitätsverlustes vereinfacht sich dann dahingehend, dass sie nur für eine Sekundärzelle erfolgt. Diese Ausgestaltung ist in Bezug auf Strom, Zeit, Entladetiefe und Ladezustand problemlos möglich. In Bezug auf insbesondere die Temperatur müssen in geeigneter Weise Mittelwerte gebildet werden oder gewichtete Mittelwerte oder Maximalwerte einzelner Zellen verwendet werden, da diese das Alterungsverhalten des Packs besser widerspiegeln.

Bei einer weiteren vorteilhaften Ausgestaltung und Weiterbildung der Erfindung wird bis zu einem Schwellenwert der C-Rate die erste Funktion und ab Überschreiten des Schwellenwertes der C-Rate die zweite Funktion verwendet. Es werden vorzugsweise für mehrere unterschiedliche Schwellenwerte der C-Rate bei Verwendung mehrerer Intervalle auch mehrere unterschiedliche Funktionen verwendet. Die C-Rate ist ein Maß dafür, mit welcher Geschwindigkeit relativ zu ihrer maximalen Kapazität eine Sekundärzelle be- oder entladen wird. Eine C-Rate von 1 bedeutet, dass ein Entladestrom die Sekundärzelle innerhalb von einer Stunde entlädt. Insbesondere werden für C-Raten < 0,2 große zeitliche Intervalle der Überprüfung der Randbedingungen zur Bestimmung des Gesamtkapazitätsverlusts gewählt. Insbesondere für C-Raten > 3 müssen hingegen kleine zeitliche Intervalle der Überprüfung der Randbedingungen (insbesondere Temperatur, Ladezustand, Spannungslage) zur Bestimmung des Gesamtkapazitätsverlusts gewählt werden, da sich die Randbedingungen schneller und häufiger signifikant ändern. Die Anzahl der Berechnungsschritte kann somit für kleine C-Raten verringert werden.

In einer weiteren vorteilhaften Ausgestaltung und Weiterbildung der Erfindung wird bis zu einem Schwellenwert einer Temperaturänderung abweichend von der aktuellen Betriebstemperatur, insbesondere Temperaturänderungen > 2°C, die erste Funktion und ab Überschreiten des Schwellenwerts die zweite Funktion verwendet. Es werden vorzugsweise für mehrere unterschiedliche Schwellenwerte der Temperatur bei Verwendung mehrerer Intervalle auch mehrere unterschiedliche Funktionen verwendet. Unterhalb des Schwellenwerts der Temperaturänderung können gleichbleibende Parameter der Randbedingungen angenommen werden, so dass die Anzahl der Berechnungsschritte minimiert wird. Dies gilt auch für die absolute Temperatur. Ab einem ersten Schwellwert, insbesondere ab 30°C, wird eine zweite Alterungsfunktion temperaturabhängig angenommen. Ebenso können weitere Temperaturgrenzwerte, bevorzugt zu höheren Temperaturen hin (aber unterhalb der erlaubten Temperaturgrenze) für weitere Funktionen angenommen werden.

In einer weiteren vorteilhaften Ausgestaltung und Weiterbildung der Erfindung werden die Teil-Kapazitätsverluste vor der Addition mit jeweils einem auf den Teil-Kapazitätsverlust angepassten Gewichtungsfaktor multipliziert. Dieser Gewichtungsfaktor beschreibt eine Schädigung der Sekundärzelle. Der Einsatz dieser Gewichtungsfaktoren ermöglicht es vorteilhaft, Parameter in den Gesamtkapazitätsverlust mit einzubeziehen, welche nicht von der Funktion erfasst werden.

In einer weiteren vorteilhaften Ausgestaltung und Weiterbildung der Erfindung umfasst der Gewichtungsfaktor einen ersten Parameter, der eine erste Schädigung durch eine Teilladung und/oder Teilentladung beschreibt. Hierbei beschreiben die Teilentladung bzw. Teilladung die Zyklentiefe. Im Betrieb wird der Sekundärzelle eine definierte Ladung insbesondere in Laderichtung aufgeprägt, bis die Zelle anschließend entladen wird. Diese wird messtechnisch erfasst. Daraus lässt sich ein Wert für die Zyklentiefe bestimmen. Dabei kann in einer weiteren Ausführungsform eine bis unterhalb eines vorgegebenen Schwellwerts aufgeprägte Entladung der Zelle ignoriert werden. Somit werden minimale Schwankungen in "Gegenrichtung" nicht als Teilzyklen in dieser Richtung verstanden. Der Grenzwert kann dabei insbesondere bei 0.1%-1.0% des SOC liegen. Dieser erste Parameter wird vorteilhaft in den Gesamtkapazitätsverlust mit einbezogen.

In einer weiteren vorteilhaften Ausgestaltung und Weiterbildung der Erfindung umfasst der Gewichtungsfaktor einen zweiten Parameter, der eine zweite Schädigung durch einen Ladezustand in Randbereichen geringer Ladezustände beschreibt. In einer weiteren vorteilhaften Ausgestaltung und Weiterbildung der Erfindung umfasst der Gewichtungsfaktor einen dritten Parameter der eine dritte Schädigung durch einen Ladezustand in Randbereichen maximaler Ladezustände beschreibt. Die Randbereiche der geringen und maximalen Ladungszustände hängen stark von der Chemie der eingesetzten Sekundärzelle ab. Insbesondere für Lithium-Ionen Zellen mit Kathoden mit Lithiummetallphosphaten (das Metall ist vorzugsweise eines der Elemente Fe, Co, Mn) befinden sich die Randbereiche für geringe Ladezustände < 20% und maximale Ladezustände > 90%. Für Lithium-Ionen-Zellen mit Oxidkathoden treten Schädigungen stark abhängig vom Potential verstärkt im oberen Ladezustandsbereich auf. Auch für Pb-Säure-Batterien, NiCd- und NiMH-Zellen und Hochtemperaturzellen (ZEBRA-Zelle, NaS-Zelle) oder Metall-Luft-Zelle können analog typische Bereiche des Ladezustands definiert werden. Weiterhin werden die Bereiche von der Chemie der Anode beeinflusst. Die stärke der Schädigung kann für unterschiedliche Bereiche im Ladezustand unterschiedlich sein. Der zweite und dritte Parameter wird vorteilhaft in den Gesamtkapazitätsverlust mit einbezogen.

In einer weiteren vorteilhaften Ausgestaltung und Weiterbildung der Erfindung umfasst der Gewichtungsfaktor einen vierten Parameter, der eine vierte Schädigung durch starke Änderungen des Ladezustands beschreibt. Starke Änderungen betreffen hierbei Änderungen des Ladezustands um mehr als 5%. Dieser dritte Parameter wird somit vorteilhaft in den Gesamtkapazitätsverlust mit einbezogen.

In einer weiteren Ausgestaltung und Weiterbildung der Erfindung umfasst der Gewichtungsfaktor einen fünften Parameter, der eine fünfte Schädigung durch fehlerhafte Betriebszustände, insbesondere Überschreiten der maximalen Betriebstemperatur, beschreibt. Dies kann auch ohne Betrieb der Sekundärzelle, insbesondere durch externe Erwärmung, erfolgen. Vorteilhaft wird die Schädigung der Sekundärzelle hier möglichst realitätsnah im Gesamtkapazitätsverlust wiedergegeben.

In einer weiteren Ausgestaltung und Weiterbildung der Erfindung, werden die Parameter mittels Messungen an wenigstens einer Sekundärzelle ermittelt. Die Parameter können dann vorteilhaft in Tabellen zusammengefasst werden. Diese Tabelle wird in einer Speichereinrichtung hinterlegt, damit auf die Daten während des Betriebs der Sekundärzelle zugegriffen werden kann. Dadurch kann die Anzahl der Messungen vermindert werden.

Die Erfindung wird nachfolgend anhand eines Ausführungsbeispiels unter Bezugnahme auf die Zeichnung noch weiter erläutert. Figur 2 zeigt zwei Funktionen, welche den Kapazitätsverlust in Abhängigkeit des Ladungsdurchsatzes beschreiben.

Die zwei Funktionen 3, 4 geben zwei unterschiedliche Randbedingungen A und B wieder. In einem ersten Schritt wird die Sekundärzelle von einem ersten Ladungsdurchsatz a bis zu einem zweiten Ladungsdurchsatz b unter Randbedingung A betrieben. Am ersten Endwert 5 ändern sich die Randbedingungen von A nach B. Die Änderung von Randbedingung A nach B beschreibt in diesem Beispiel eine Temperaturänderung abweichend von der ursprünglichen Betriebstemperatur um 5°C.

Es wird für den Weiterbetrieb unter Randbedingung B für denselben Kapazitätsverlust des ersten Endwerts 5 der Randbedingung A der Schnittpunkt mit der Funktion für Randbedingung B bestimmt. Dieser dient nun als zweiter Anfangswert 6 für den Betrieb der Sekundärzelle unter Randbedingung B. Die Sekundärzelle wird nun unter Randbedingung B vom zweiten Ladungsdurchsatz b bis zu einem dritten Ladungsdurchsatz c betrieben. Der zweite Ladungsdurchsatz b verschiebt sich mit dem zweiten Anfangswert 6 hin zu einem vierten Ladungsdurchsatz b2. Auch der dritte Ladungsdurchsatz c verschiebt sich hin zu einem fünften Ladungsdurchsatz c2. Nach Erreichen des zweiten Endwerts 7 ändern sich die Randbedingungen wiederum von B nach A. Die Bestimmung des dritten Anfangswerts 8 erfolgt analog bei konstantem Kapazitätsverlust 1. Der erste Teil-Kapazitätsverlust 9 und der zweite Teil-Kapazitätsverlust 10 für die Ladungsdurchsatzbereiche a bis b und b bis c können vorteilhaft an der y-Achse direkt abgelesen werden.

Der erste Teil-Kapazitätsverlust 9 wird für einen Ladungsdurchsatz von a bis b bestimmt. Die Sekundärzelle wurde währenddessen im Randbereich eines Ladezustands > 90% betrieben. Der erste Teil-Kapazitätsverlust wird deshalb mit einem Faktor von 1,2 gewichtet, so dass der Gesamtkapazitätsverlust höher ist als nach Addition der nicht gewichteten ersten und zweiten Teil-Kapazitätsverluste 9 und 10.

**Patentansprüche**

1. Verfahren zur Bestimmung eines Gesamtkapazitätsverlusts einer Sekundärzelle bei Durchlaufen eines ersten Intervalls von einem ersten Anfangswert bis zu einem ersten Endwert (5) für einen Ladungsdurchsatz (2) und eines sich an das erste Intervall anschließenden zweiten Intervalls von einem zweiten Anfangswert (6) bis zu einem zweiten Endwert (7) für den Ladungsdurchsatz (2), wobei der Gesamtkapazitätsverlust und der Ladungsdurchsatz (2) über den Zusammenhang $Q_{loss} = B \cdot \exp\left(\dfrac{-E_a}{RT}\right) \cdot (I * t)^z$ beschrieben werden, in welchem $Q_{loss}$ der

   Kapazitätsverlust, R die universelle Gaskonstante, T eine Temperatur, I ein Strom, t eine Zeit, B ein an Randbedingungen der Sekundärzelle anpassbarer Vorfaktor, $E_a$ eine an Randbedingungen der Sekundärzelle anpassbare Aktivierungsenergie und z ein an Randbedingungen der Sekundärzelle anpassbarer Exponent ist, wobei bei dem Verfahren

   - ein erster Teil-Kapazitätsverlust (9) mittels einer ersten Funktion (4), welche den Zusammenhang zwischen dem Ladungsdurchsatz (2) und dem Kapazitätsverlust (1) mit einer ersten Randbedingung beschreibt, für das erste Intervall mit dem ersten Endwert (5) bestimmt wird,
   - ein zweiter Teil-Kapazitätsverlust (10) mittels einer zweiten Funktion (3), welche den Zusammenhang zwischen dem Ladungsdurchsatz (2) und dem Kapazitätsverlust (1) mit einer zweiten Randbedingung beschreibt, für das zweite Intervall bestimmt wird,
   - der Gesamtkapazitätsverlust mittels Addition der Teil-Kapazitätsverluste (9, 10) bestimmt wird,
   **dadurch gekennzeichnet, dass**
   das zweite Intervall für die Verwendung in der zweiten Funktion (3) derart verschoben wird, dass ein Ergebniswert der zweiten Funktion für den zweiten Anfangswert (6) einem Ergebniswert der ersten Funktion für den ersten Endwert (5) entspricht.

2. Verfahren nach Anspruch 1, wobei bis zu einem Schwellenwert einer C-Rate, welche ein Maß dafür ist, mit welcher Geschwindigkeit relativ zu ihrer maximalen Kapazität eine Sekundärzelle be- oder entladen wird, die erste Funktion (4) und ab Überschreiten eines Schwellenwerts der C-Rate die zweite Funktion (3) verwendet wird.

3. Verfahren nach einem der vorangegangenen Ansprüche, wobei bis zu einem Schwellenwert einer Temperaturänderung abweichend von einer Betriebstemperatur die erste Funktion(4) und ab Überschreiten des Schwellenwerts die zweite Funktion (3) verwendet wird.

4. Verfahren nach einem der Ansprüche 1 bis 3, wobei die Teil-Kapazitätsverluste (9, 10) vor der Addition mit jeweils einem auf den Teil-Kapazitätsverlust angepassten Gewichtungsfaktor multipliziert werden, der eine Schädigung der Sekundärzelle beschreibt.

5. Verfahren nach Anspruch 4, wobei der Gewichtungsfaktor einen ersten Parameter umfasst, der eine erste Schädigung durch eine Teil-Ladung und/oder Teil-Entladung beschreibt.

6. Verfahren nach Anspruch 4 oder 5, wobei der Gewichtungsfaktor einen zweiten Parameter umfasst, der eine zweite Schädigung durch einen Ladezustand in Randbereichen geringer Ladezustände, insbesondere Ladezustände kleiner 20%, beschreibt.

7. Verfahren nach einem der Ansprüche 4 bis 6, wobei der Gewichtungsfaktor einen dritten Parameter umfasst, der eine dritte Schädigung durch einen Ladezustand in Randbereichen maximaler Ladezustände, insbesondere Ladezustände größer 90%, beschreibt.

8. Verfahren nach einem der Ansprüche 4 bis 7, wobei der Gewichtungsfaktor einen vierten Parameter umfasst, der eine vierte Schädigung durch starke Änderungen des Ladezustands, insbesondere Änderungen um mehr als 5%, beschreibt.

9. Verfahren nach einem der Ansprüche 4 bis 8, derart ausgestaltet, dass der Gewichtungsfaktor einen fünften Parameter umfasst, der eine fünfte Schädigung durch fehlerhafte Betriebszustände beschreibt.

10. Verfahren nach einem der Ansprüche 4 bis 9, derart ausgestaltet, dass wenigstens zwei Teil-Kapazitätsverluste wenigstens einen gleich bleibenden Parameter umfassen.

11. Verfahren nach einem der vorangegangenen Ansprüche, derart ausgestaltet, dass die Parameter mittels Messungen an wenigstens einer Sekundärzelle ermittelt werden.

## Claims

1. Method for determining an overall loss of capacitance of a secondary cell upon passage of a first interval from a first initial value up to a first final value (5) for a charge throughput (2), and of a second interval, following the first interval, from a second initial value (6) up to a second final value (7) for the charge throughput (2), wherein the overall loss of capacitance and the charge throughput (2) are described via the relationship

$$Q_{loss}=B \cdot exp\left[\frac{-E_a}{RT}\right] \cdot (I \star t)^2,$$ in which $Q_{loss}$ is the loss of capacitance, R is the universal gas constant, T is a temperature, t is a time, B is a prefactor which can be adjusted to boundary conditions of the secondary cell, $E_a$ is an activation energy which can be adjusted to boundary conditions of the secondary cell, and z is an exponent which can be adjusted to boundary conditions of the secondary cell, wherein, in the method,

- a first partial loss of capacitance (9) is determined for the first interval with the aid of the first final value (5) by means of a first function (4) which describes the relationship between the charge throughput (2) and the loss of capacitance (1) with a first boundary condition,
- a second partial loss of capacitance (10) is determined for the second interval by means of a second function (3) which describes the relationship between the charge throughput (2) and the loss of capacitance (1) with a second boundary condition,
- the overall loss of capacitance is determined by means of adding the partial losses of capacitance (9, 10),

**characterized in that** the second interval is displaced for use in the second function (3) in such a way that a result value of the second function for the second initial value (6) corresponds to a result value of the first function for the first final value (5) .

2. Method according to Claim 1, wherein the first function (4) is used up to a threshold value of a C rate, which is a measure of the speed at which a secondary cell is charged or discharged relative to its maximum capacitance, and the second function (3) is used starting from overshooting of a threshold value of the C rate.

3. Method according to one of the preceding Claims, wherein the first function (4) is used up to a threshold value of a change in temperature deviating from an operating temperature, and the second function (3) is used starting from overshooting of the threshold value.

4. Method according to one of Claims 1 to 3, wherein before the addition the partial losses of capacitance (9, 10) are multiplied in each case by a weighting factor which is adjusted to the partial loss of capacitance and describes an instance of damage to the secondary cell.

5. Method according to Claim 4, wherein the weighting factor comprises a first parameter which describes a first instance of damage owing to a partial charging and/or partial discharging.

6. Method according to Claim 4 or 5, wherein the weighting factor comprises a second parameter, which describes a second instance of damage owing to a state of charge in extreme regions of low states of charge, in particular states of charge less than 20%.

7. Method according to one of Claims 4 to 6, wherein the weighting factor comprises a third parameter, which describes a third instance of damage owing to a state of charge in extreme regions of maximum states of charge, in particular states of charge greater than 90%.

8. Method according to one of Claims 4 to 7, wherein the weighting factor comprises a fourth parameter, which describes a fourth instance of damage owing to marked changes in the state of charge, in particular changes by more than 5%.

9. Method according to one of Claims 4 to 8, which are configured in such a way that the weighting factor comprises a fifth parameter, which describes a fifth instance of damage owing to faulty operating states.

10. Method according to one of Claims 4 to 9, which is configured in such a way that at least two partial losses of capacitance comprise at least one constant parameter.

11. Method according to one of the preceding claims, which is configured in such a way that the parameters are determined by means of measurements on at least one secondary cell.

## Revendications

1. Procédé de détermination d'une perte totale de capacité d'un élément secondaire, lorsque s'écoule un premier intervalle d'une première valeur initiale à une première valeur (5) finale d'un débit (2) de charge et un deuxième intervalle faisant suite au premier intervalle d'une deuxième valeur (6) initiale à une deuxième valeur (7) finale du débit (2) de charge, la perte totale de capacité et le débit (2) de charge étant décrits par la relation

$$Q_{loss} = B \cdot exp\left(\frac{-E_a}{RT}\right) \cdot \left(I^* t\right)^z$$ dans laquelle $Q_{loss}$ est la perte de capacité, R est la constante universelle des gaz, T est une température, I est un courant, t est un temps, B est un facteur pouvant être adapté aux conditions aux limites de l'élément secondaire, $E_a$ est une énergie d'activation pouvant être adaptée aux conditions aux limites de l'élément secondaire et z est un exposant pouvant être adapté aux conditions aux limites de l'élément secondaire, dans lequel, dans le procédé

- on détermine, pendant le premier intervalle ayant la première valeur (5) finale, une première perte (9) partielle de capacité, au moyen d'une première fonction (4), qui décrit la relation entre le débit (2) de charge et la perte (1) de capacité à une première condition aux limites,
- on détermine, pendant le deuxième intervalle, une deuxième perte (10) partielle de capacité, au moyen d'une deuxième fonction (3), qui décrit la relation entre le débit (2) de charge et la perte (1) de capacité, à une deuxième condition aux limites,
- on détermine la perte totale de capacité au moyen de l'addition des pertes (9, 10) partielles de capacité, **caractérisé en ce que**
on décale le deuxième intervalle pour l'utilisation dans la deuxième fonction (3), de manière à ce qu'une valeur de résultat de la deuxième fonction, pour la deuxième valeur (6) initiale, corresponde à une valeur de résultat de la première fonction pour la première valeur (5) finale.

2. Procédé suivant la revendication 1, dans lequel, jusqu'à une valeur de seuil d'une vitesse C, qui est une mesure de la vitesse, par rapport à sa capacité maximum, à laquelle un élément secondaire est chargé ou déchargé, on utilise la première fonction (4) et, à partir du dépassement d'une valeur de seuil de la vitesse C, la deuxième fonction (3).

3. Procédé suivant l'une des revendications précédentes, dans lequel, jusqu'à une valeur de seuil d'une variation de température s'écartant d'une température de fonctionnement, on utilise la première fonction (4) et, à partir du dépassement de la valeur de seuil, la deuxième fonction (3).

4. Procédé suivant l'une des revendications 1 à 3, dans lequel on multiplie les pertes (9, 10) partielles de capacité avant l'addition, par, respectivement, un facteur de pondération, qui est adapté à la perte partielle de capacité et qui décrit un endommagement de l'élément secondaire.

5. Procédé suivant la revendication 4, dans lequel le facteur de pondération comprend un premier paramètre, qui décrit un premier endommagement par une charge partielle et/ou une décharge partielle.

6. Procédé suivant la revendication 4 ou 5, dans lequel le facteur de pondération comprend un deuxième paramètre, qui décrit un deuxième endommagement par un état de charge dans des plages limites d'états de charge petits, notamment, d'états de charge plus petits que 20%.

7. Procédé suivant l'une des revendications 4 à 6, dans lequel le facteur de pondération comprend un troisième paramètre, qui décrit un troisième endommagement par un état de charge dans des plages limites d'états de charge maximum, notamment d'états de charge plus grands que 90%.

8. Procédé suivant l'une des revendications 4 à 7, dans lequel le facteur de pondération comprend un quatrième paramètre, qui décrit un quatrième endommagement par de fortes variations de l'état de charge, notamment des variations de plus de 5%.

9. Procédé suivant l'une des revendications 4 à 8, conformé de manière à ce que le facteur de pondération comprenne un cinquième facteur de charge, qui décrit un cinquième endommagement par des états de fonctionnement défectueux.

10. Procédé suivant l'une des revendications 4 à 9, conformé de manière à ce qu'au moins deux pertes partielles de capacité comprennent au moins un paramètre, qui reste pareil.

11. Procédé suivant l'une des revendications précédentes, qui est conformé de manière à ce que les paramètres soient déterminés au moyen de mesures sur au moins un élément secondaire.

## FIG 1

## FIG 2

**IN DER BESCHREIBUNG AUFGEFÜHRTE DOKUMENTE**

**In der Beschreibung aufgeführte Patentdokumente**

- EP 1450173 A2
- DE 19540827 A1
- EP 1387177 A2

**In der Beschreibung aufgeführte Nicht-Patentliteratur**

- **JOHN WANG et al.** *Journal of Power Sources,* 2011, vol. 196, 3942-3948